# EUROPEAN PATENT SPECIFICATION

(11) **EP 2 472 331 B1**
(45) Date of publication and mention of the grant of the patent: **06.06.2018**
(21) Application number: 11771574.8
(22) Date of filing: 19.04.2011
(51) Int. Cl.: G03F 7/16, H01L 21/027, B05C 9/06, B05C 5/02

(54) **GUMMING DEVICE AND METHOD**
GUMMIERUNGSVORRICHTUNG UND VERFAHREN
DISPOSITIF ET PROCÉDÉ DE GOMMAGE

(30) Priority: 19.04.2010 CN 201010154127
(43) Date of publication of application: 04.07.2012
(73) Proprietor: Beijing BOE Optoelectronics Technology Co., Ltd., Beijing 100176 (CN)
(72) Inventor: ZHOU, Weifeng, Beijing 100176 (CN); GUO, Jian, Beijing 100176 (CN); MING, Xing, Beijing 100176 (CN)
(74) Representative: Klunker IP Patentanwälte PartG mbB
(86) International application number: PCT/CN2011/073010
(87) International publication number: WO 2011/131121

(56) References cited:
- CN-A- 1 593 787
- CN-A- 1 710 489
- CN-A- 1 824 392
- CN-A- 101 142 032
- CN-A- 101 192 008
- JP-A- 7 321 001
- JP-A- 2000 102 759
- JP-A- 2004 130 280
- JP-A- 2007 090 205
- JP-A- 2007 240 859
- JP-A- 2010 040 323
- JP-A- 2011 062 401
- US-A- 4 938 994
- US-A- 5 136 970
- US-A- 5 700 325
- US-A- 5 919 520

## Description

### Technical Field

The present invention relates to a resist coating method.

### BACKGROUND

There is a fast improvement in the field of Liquid Crystal Display (LCD) in the past two decades, ranging from the size of displays to performances such as display quality. With continuous efforts, all aspects of LCD have reached the level of conventional cathode ray tube (CRT) displays, with a trend of replacing CRTs with LCDs.

As the manufacturing of LCD continues to advance, the competitions between various manufacturers are getting fiercer. The competitiveness of products is improved due to continuous improvements in the quality of the products as well as lowering of the manufacturing costs.

Multi-domain mask exposure is currently among the developing trends of lithography. The manufacturing capacities can be increased and the costs can be decreased through multi-domain mask exposure. As for now, multi-domain mask exposure may be realized by fabricating a multi-domain region in resist with a broad light sensitive scale.

Currently, two layers of resist are fabricated using the following steps: coat a first layer of a first kind resist, then coat a second layer of a second kind of resist; or, two or more nozzles with a relative large space in-between are used to coat layers of resist successively.

In such case, as the first kind of resist layer has not become solidified when the second kind of resist layer is coated, and in order to avoid the contamination to the second kind of resist by the first kind of resist due to the liquid surface tension, the nozzle of the second kind of resist may not be located within a certain short distance from the first resist layer, thereby causing air bubbles between the two layers, leading to defects in multi-domain mask exposure.

US 5,919,520 discloses a spin type coating apparatus having a movable beam in which first and second nozzles are integrally formed. The first nozzle is used for supplying a photo-resist liquid while the second nozzle is used for supplying a solvent for the photo-resist liquid. When the coating process is performed, the movable beam above the wafer is horizontally moved in one direction. The solvent is first supplied onto the wafer from the second nozzle, and the coating or photo-resist liquid is then supplied from the first nozzle, following the solvent.

US 4,938,994 discloses an apparatus for premetered "patch" coating discrete, incremental surfaces or substrates with a pre-configured layer of a liquid in which a controlled volume per unit area of the liquid is applied to the substrate. One embodiment shows a multi-layer premetered "patch" coating applicator with two separate coating systems for "one pass" coating two separate coatings.

JP 2000-102759 discloses a coating method and coating device as well as production of plasma display and member for display and apparatus for production thereof.

JP 2004-130280 discloses thin film forming device, wherein a thick coating liquid in a storage section and a thin coating liquid in a storage section are discharged respectively from respective slits of a coating part so that a coating liquid prepared by mixing these liquids is coated on the surface of a substrate.

JP 2007-240859 discloses a die coating apparatus with a nozzle unit provided with two discharge ports in a nozzle portion to be used in a die coating method, in which simultaneously two coating liquids are separately discharged and applied to a two-ply sheet.

JP 2007-090205 discloses a coating apparatus is constituted of a first ejection port from which a first coating liquid is ejected, a second ejection port from which a second coating liquid is ejected, and a third ejection port from which the first coating liquid is ejected, each disposed in line from upstream to downstream wherein the gap between the first ejection port and an object to be coated is narrower than the gaps between the object to be coated and the second ejection port and the third ejection port respectively.

US 5,700,325 discloses a coating device for forming a coating film in a predetermined pattern by applying a coating material from a nozzle to a surface of a base material which continuously travels. The nozzle includes: a front block provided upstream with respect to a traveling direction of the base material, a top face of the front block opposing to the traveling base material being a curved face which has a predetermined curvature radius; and a back block provided downstream with respect to the traveling direction of the base material, a top face of the back block opposing to the traveling base material being a flat face. The front block is provided so as to project toward the base material with respect to the back block, and a plurality of discharging openings are provided on the flat face of the back block for discharging the coating material therethrough.

JP 2010-040323 discloses a liquid drop discharge device with a nozzle plate having a row of nozzles consisting of a plurality of liquid drop discharge ports with different hole diameters and forming a line pattern on a substrate by discharging ink from each liquid drop discharge port. The plurality of liquid drop discharge ports are arranged on a straight line to the line forming direction and enable to increase the liquid drop density in the formed line to suppress the film-thickness unevenness (coating unevenness), and to repair the line by coating on a defect such as a line disconnection. Further, by selecting the liquid drop discharge ports arranged in the line forming direction and changing the hole diameters thereof, the discharge resistance can be controlled.

### SUMMARY

It is an object of the present invention to provide resist coating method which can reduce or avoid generation of air bubbles between layers.

The object is solved by the features of the respective independent claim. Further embodiments are defined in the respective dependent claim.

### BRIEF DESCRIPTION OF THE DRAWINGS

Following is a description of the drawings being referred to during the description of the embodiment or the current art, in order to better explain the technical solutions in the embodiments of the present invention or of the current art. Apparently, the accompany drawings in the following description are merely samples of the present invention. As to those ordinarily skilled in the art, other drawings may be contemplated based on these accompany drawings without creative works.
Fig.1 is a schematic drawing of the resist coating device used in the coating methods according to the embodiments of the present invention ;
Fig.2 is a schematic drawing of a side view of the nozzle used in the coating methods according to the embodiments of the present invention;
Fig.3 is a schematic drawing of another side view of the nozzle used in the coating methods according to the embodiments of the present invention;
Fig.4 is a schematic drawing of a side view of a multi-layered resist coated by the nozzle used in the coating methods according to the embodiments of the present invention;
Fig.5 is a schematic drawing of a bottom view of the nozzle used in the coating methods according to the embodiments of the present invention;
Fig.6 is a schematic drawing of another bottom view of the nozzle used in the coating methods according to the embodiments of the present invention; and
Fig.7 is a schematic drawing of another side view of the nozzle used in the coating methods according to the embodiments of the present invention.

### DETAILED DESCRIPTION OF THE EMBODIMENTS

Following is provided to illustrate the technical solutions of the present invention clearly and completely, in conjunction with the accompany drawings of the embodiments of the present invention. Apparently, the depicted embodiments are merely a portion of the embodiments, rather than all of the embodiments of the present invention. Based on the embodiments of the present invention, those ordinarily skilled in the art can contemplate, without creative works, other embodiments of the present invention, which are within the scope of the present invention.

The resist coating device comprises: a nozzle, a resist feeding mechanism connected with the nozzle and a nozzle moving mechanism; at least two rows of resist injection holes are included in the nozzle, and the two adjacent rows of resist injection holes are separated by a spacer.

A description of the present invention is provided as follows with reference to the resist coating device for applying resists. However, the present invention is not limited to applying photoresist; all those satisfying the conditions of the present inventions are within the scope of the present invention.

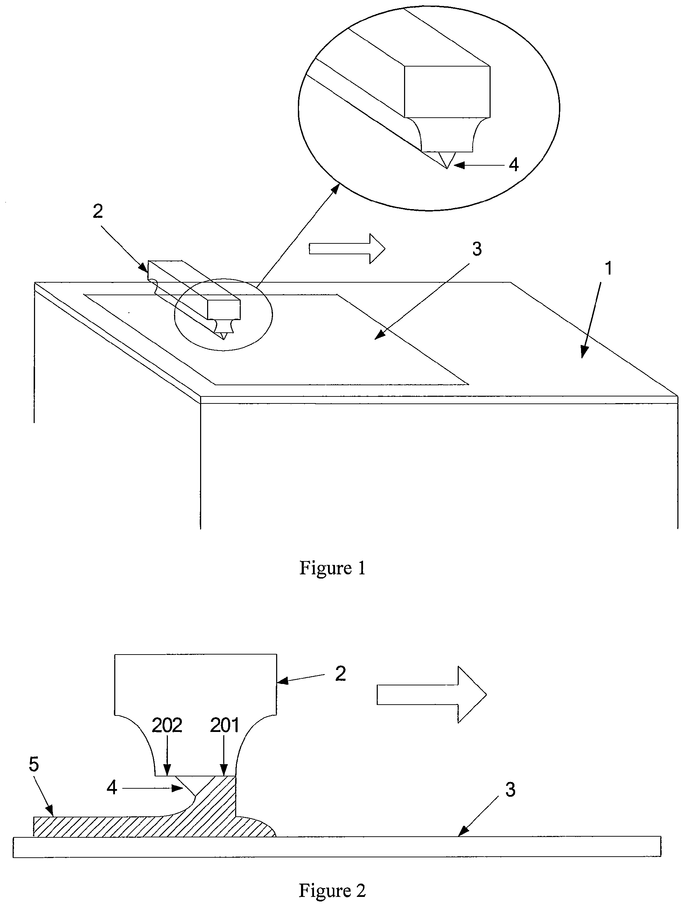

As shown in Fig.1, the resist coating device comprises: a platform 1, a nozzle 2, a resist feeding mechanism connected with the nozzle (not shown) and a nozzle moving mechanism (not shown) moving the nozzle 2. In addition, the substrate 3 for the resist to be applied thereon is placed on the platform 1.

A nozzle 2 includes at least two rows of resist injection holes, and the two adjacent rows of resist injection holes are separated by a spacer 4. For example, as shown in Fig.1, a nozzle 2 includes two rows of resist injection holes, and the two adjacent rows of resist injection holes are separated by a spacer 4. As such, during the movement of the nozzle 2, multilayer resists can be applied by opening each row of resist injection holes successively or in order to apply resist at different timings, thereby coating of resist layers can realized by one movement of single nozzle. After completion of resist coating, lithography is completed with several processes including low pressure drying, baking, exposing, developing, etching etc., to fabricate for example corresponding conductive patterns on array substrates.

In the resist coating device, the nozzle of the device includes at least two rows of resist injection holes, and the two adjacent rows of resist injection holes are separated by a spacer. During resist coating, layers of resist are applied by opening each row of resist injection holes successively, thereby completing the coating of the resist layers in one movement of single nozzle. As such, it is possible to avoid nozzles for coating of layers of resist, and also further possible to avoid air bubbles occurring between layers due to deviations of locations of the nozzles during resist coating, thereby decreasing the defect ratio of multi-domain mask exposure, improving quality and efficiency of thin film transistor liquid crystal displays (TFT-LCDs).

### First embodiment of nozzle

Fig.2 is a schematic drawing of a side view of the nozzle. In this embodiment, for example, a nozzle 2 includes two rows of resist injection holes 201, 202.

As shown in Fig.2, the nozzle 2 includes two rows of resist injection holes 201, 202, and the two adjacent rows of resist injection holes are separated by a spacer 4 in a wedge shape. When the nozzle2 moves in a direction as indicted by the arrow, due to the wedge slope of the wedge spacer 4, a first layer of resist 5 injected by the row of resist injection holes 201 can flow smoothly along the wedge slope of the wedge spacer 4 to adhere to a substrate 3.

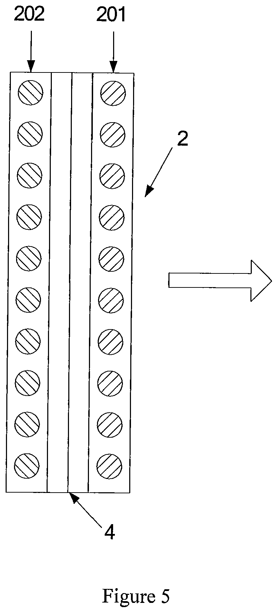

Fig.5 is a schematic drawing of a bottom view of the nozzle 2 in Fig.2. It can be clearly seen from Fig.5 that, the nozzle 2 includes two rows of resist injection holes 201, 202; each row of the resist injection holes comprises resist injection holes arranged in a row transverse to the moving direction of nozzle 2 (the arrow direction). Two adjacent rows of resist injection holes are separated by the wedge spacer 4.

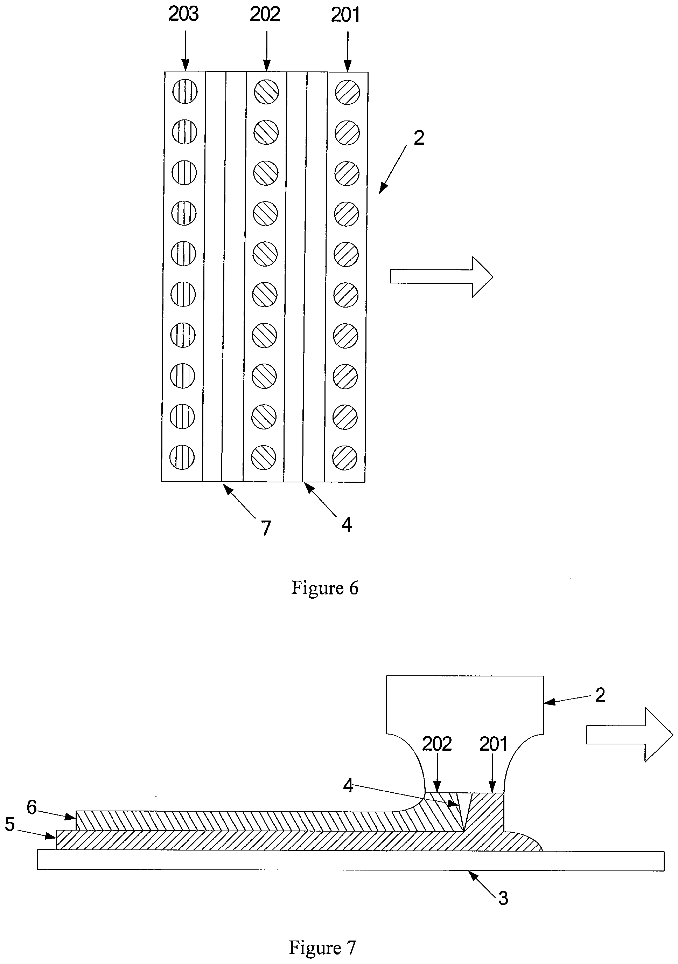

Furthermore, when there are a plurality of rows of resist injection holes in nozzle 2, for example, three rows of resist injection holes 201, 202, 203 as shown in Fig.6, similarly each row of the resist injection holes comprises resist injection holes arranged in a row transverse to the moving direction of nozzle 2 (the arrow direction), two adjacent rows of resist injection holes 201 and 202 are separated by a wedge spacer 4 , and the rows of resist injection holes 202 and 203 are separated by a wedge spacer 7. In case of more rows of resist injection holes, they are also arranged in such manner.

One preferred configuration is that, as shown in Fig.7, the wedge spacer 4 is relatively long, with the top end of the extension portion being in right contact with the top surface of the resist 5 applied by the first row of resist injection holes 201 during resist coating. A more preferable layered structure between layers of resist can be maintained by using such a wedge spacer, and the top end of this wedge spacer 4 can level off the prior layer before coating the next layer of resist during the movement.

In other embodiment of the present invention, the shape of the spacer disposed between the two rows of injection holes are not limited to a wedge shape, other shapes such as a hemispherical shape, a trapezoid shape or like, or a combination of these above can be employed; furthermore, in case of the cross section of the spacer in a wedge shape, the sides of the wedge may be curved, such as an inward concave or an outward convex. In addition, the spacer may be replaceable, such that differently shaped (such as cross sections, heights and etc.) spacers can be used for different kinds of resist.

The description of the resist coating method utilizing the resist coating device according to the embodiments of the present invention is provided as follows. The embodiment of the method comprises:

S801: Place a substrate on the platform, adjust the distance between the substrate and the nozzle to a proper value. For example, a top end of the extension portion of the spacer between two rows of resist injection holes is in right contact with the top surface of the resist to be coated below it during resist coating.

S802: the nozzle is moved on the substrate by a nozzle moving mechanism, and each row of resist injection holes in the nozzle is successively opened in a direction opposite to the moving direction of nozzle for applying resist. The moving velocity of the nozzle may be decided according to the factors such as type, characteristics, and so on of the resist to be applied.

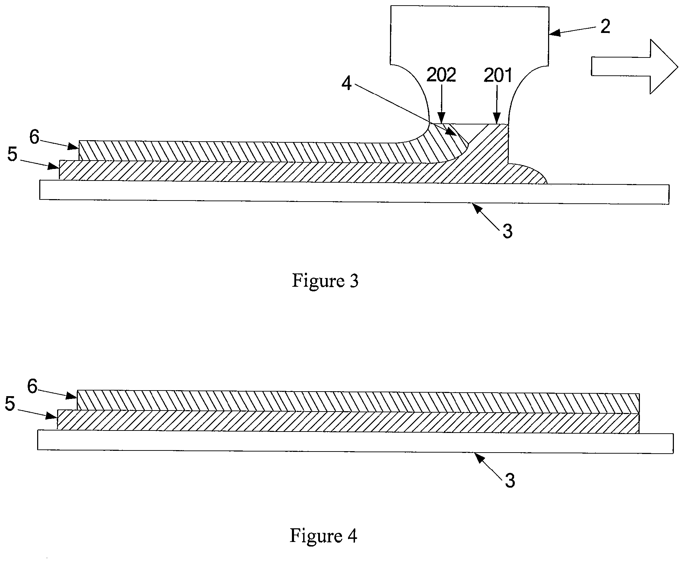

In particular, when two rows of resist injection holes are used to coat two layers of resist for example, as shown in Fig.2, the first row of resist injection holes 201 on the left side of the nozzle 2 is opened first during resist coating, to fabricate a resist coating start region with a length of 1-5 mm (i.e., a predetermined length) of the first layer of resist 5 on the edge of the substrate 3, and after lasting of 5-30 seconds (a predetermined time period) a compact protection film is formed in the top surface of the resist coating start region of the first layer of resist 5 due to volatilization of the solution. As shown in Fig.3, the second row of resist injection holes 202 is then opened to inject the second layer of resist 6, due to the compactness of the top surface of the first layer of resist 5, an obvious delamination of the first layer of resist 5 and the second layer of resist 6 occurs in the resist coating start region, the nozzle 2 is then moved from one side of the substrate 3 till the other side, thereby coating two relatively obvious layers of resist under the guiding of the delamination in the resist coating start region. In case of more than two rows of resist injection holes included in the nozzle 2, the above steps are repeated till each row of the resist injection holes is opened for resist coating.

S803: Upon completion of resist coating, the first and the second row of resist injection holes 201,202 are closed. Two layers of resist are achieved as shown in Fig.4, with few or substantially no air bubbles between the layers.

Here the two rows of injection holes may be closed at the same time, or the first row of resist injection holes may be closed first, followed by the close of the second row of resist injection holes.

S804: The substrate undergoes a low pressure drying process during the first predetermined time period after completion of resist coating.

Due to the liquid fluidity of resist, the two layers of resist as fabricated may interdiffuse into each other over time, thereby the coated substrate must be sent to next step within a short time period. For example, the inventors found that the resist with a viscosity of 8-10 CP may stay in the delamination state of two layers within 20 seconds (i.e., the first predetermined time period), thus the low pressure drying must be conducted within 20 seconds to remove most solution in the resist, thereby solidifying the resist. For resist with lower viscosities, the corresponding time period may be relatively shorter. In contrast, for resists with higher viscosities, the corresponding time period may be relatively longer.

S805: The substrate is pre-baked during the second predetermined time period after the completion of the low pressure drying.

Similarly, the inventors found that within 60 seconds (i.e., the second predetermined time period), the interdiffusions between different layers of resist may be prevented by a pre-bake process to remove the remaining water and solution within the resist, thereby solidifying the resist thoroughly to form a stable layered structure of the two layers of resist.

The lithography is conducted after steps including exposing, developing, etching, etc.

In the present embodiment, a multi-domain gray-scaled resist topography can be easily formed due to the different properties of the two kinds of resist. In addition, if a kind of resist with relative better adhesion to the glass substrate is selected for the bottom layer, the etching retraction amount of the resist can be effectively decreased, thereby improving the wiring capacity.

It should be noted that the present embodiment is described with reference to two layers of resist, but coating, low pressure drying and pre-baking for a plurality of layers of resist are similar to those of the above embodiment, the plurality of layers of resists are formed by coating at different timings followed by low pressure drying and pre-baking within a short time period.

In the resist coating device and method according to the present invention, rows of resist injection holes are included in a nozzle, and the two adjacent rows of resist injection holes are separated by a spacer. During resist coating, layers of resist can be applied by opening each row of resist injection holes successively or in order, thereby completing the resist coating by one movement of single nozzle. As such, it is possible to avoid nozzles for resist coating of resist layers, and also possible to avoid air bubbles between layers due to deviations of locations of the nozzles during resist coating, thereby decreasing the defect ratio of multi-domain mask exposure, improving quality and efficiency of TFT-LCDs.

The embodiment of the processes provided above is merely the preferred embodiments to carry out the invention, not the only one implementation of the present invention. Different materials, processing parameters and equipments may be used depending on the requirements of different manufacturing lines.

Above are merely specific embodiments of the present invention; however, they are not intended to limit the scope of the present invention in any manner. Those ordinary skilled in the art may easily recognize various modifications or alternations within the scope of the present invention being disclosed. Thus, the scope of the present invention shall be determined in the appended claims.

## Claims

1. A resist coating method, comprising:
moving a nozzle (2) on a substrate (3) by a nozzle moving mechanism, wherein at least two rows of resists injection holes (201, 202) are included in the nozzle (2) and the two adjacent rows of resist injection holes (201, 202) are separated by a spacer (4), and
opening each row of resist injection holes (201, 202) in the nozzle (2) successively in a direction opposite to the moving direction of the nozzle (2) for resist application;,
**characterized in that**
an extension portion of the spacer (4) extends from a plane in which openings of the resist injection holes (201, 202) are provided and forming a height difference between a top end of extension portion and the plane, and
a first row of the two adjacent rows of resist injection holes (201, 202) is firstly opened to form a resist coating start region of a first layer of resist (5),
a protection film is formed in a top surface of the resist coating start region through volatilization of a solution in the first layer of resist (5), and
then a second row of the two adjacent rows of resist injection holes (201, 202) is opened to form a second layer of resist (6),
wherein delamination of the first layer of resist (5) and the second layer of resist (6) occurs in the resist coating start region due to the protection film formed in the top surface of the resist coating start region.

2. The method according to Claim 1, wherein opening each row of the resist injection holes (201, 202) in the nozzle (2) successively in the direction opposite to the moving direction of the nozzle (2) for resist application comprises:
in a direction opposite to the moving direction of the nozzle (2), opening the first row of resist injection holes (201) first during resist coating to form the resist coating start region of the first layer of resist (5) with a predetermined length on an edge of the substrate (3), and after a predetermined time period, then opening the second row of resist injection holes (202) adjacent to the first row of resist injection holes (201).

3. The method according to Claim 1, wherein the second row of resist injection holes (202) is opened to form a second resist coating start region with a predetermined length, and after for a second predetermined time, the operations of the second row of resist injection holes (202) is repeated till each of the remaining rows of resist injection holes is opened, then resist is applied.

4. The method according to Claim 1, further comprising:
conducting a low pressure drying on the substrate (3) after completion of the resist application.

5. The method according to Claim 4, further comprising:
conducting a pre-baking on the substrate (3) after completion of the lower pressure drying.

6. The method according to Claim 1, wherein moving the nozzle (2) on the substrate (3) by the nozzle moving mechanism comprises:
moving the nozzle (2) by the nozzle moving mechanism from one side of the substrate (3) till the other side.

7. The method according to Claim 1, wherein the spacer (4) comprises a wedge shape.

8. The method according to Claim 7, wherein a top end of an extension portion of the spacer (4) in a wedge shape contacts a top surface of the resist applied below.

## Patentansprüche

1. Fotolack-Auftragverfahren aufweisend:
Bewegen einer Düse (2) auf einem Substrat (3) mittels eines Düsen-Bewegungsmechanismus, wobei wenigstens zwei Reihen Fotolack-Spritzlöcher (201, 202) in der Düse (2) vorgesehen sind und die zwei benachbarten Reihen Fotolack-Spritzlöcher (201, 202) durch einen Abstandshalter (4) voneinander getrennt sind, und
Öffnen jeder Reihe Fotolack-Spritzlöcher (201, 202) in der Düse (2) der Reihe nach in einer Richtung entgegengesetzt der Bewegungsrichtung der Düse (2) zur Fotolackauftragung,
**dadurch gekennzeichnet, dass**
ein Fortsatz-Abschnitt des Abstandshalters (4) sich von einer Ebene erstreckt, in der Öffnungen der Fotolack-Spritzlöcher (201, 202) vorgesehen sind, und einen Höhenunterschied zwischen einem oberen Ende des Fortsatz-Abschnitts und der Ebene bildet, und
eine erste Reihe der zwei benachbarten Reihen Fotolack-Spritzlöcher (201, 202) zuerst geöffnet wird, um einen Fotolack-Auftragungsstartbereich einer ersten Fotolack-Schicht (5) zu bilden,
eine Schutz-Dünnschicht in einer Oberseite des Fotolack-Auftragungsstartbereichs durch Verflüchtigung einer Lösung in der ersten Fotolack-Schicht (5) gebildet wird, und
dann eine zweite Reihe der zwei benachbarten Reihen Fotolack-Spritzlöcher (201, 202) geöffnet wird, um eine zweite Fotolack-Schicht (6) zu bilden,
wobei eine Delaminierung der ersten Fotolack-Schicht (5) und der zweiten Fotolack-Schicht (6) in den Fotolack-Auftragungsstartbereich aufgrund der ausgebildeten Schutz-Dünnschicht in der Oberseite des Fotolack-Auftragungsstartbereichs auftritt.

2. Verfahren gemäß Anspruch 1, wobei Öffnen jeder Reihe Fotolack-Spritzlöcher (201, 202) in der Düse (2) der Reihe nach in der Richtung entgegengesetzt der Bewegungsrichtung der Düse (2) zur Fotolack-Auftragung aufweist:
in einer Richtung entgegengesetzt der Bewegungsrichtung der Düse (2), Öffnen der ersten Reihe Fotolack-Spritzlöcher (201) zuerst während dem Fotolackauftragen, um den Fotolack-Auftragungsstartbereich der ersten Fotolack-Schicht (5) mit einer vorbestimmten Länge am Rand des Substrats (3) zu bilden, und nach einer vorbestimmten Zeitdauer, dann Öffnen der zweiten Reihe Fotolack-Spritzlöcher (202) benachbart zur ersten Reihe Fotolack-Spritzlöcher (201).

3. Verfahren gemäß Anspruch 1, wobei die zweite Reihe Fotolack-Spritzlöcher (202) geöffnet wird, um einen zweiten Fotolack-Auftragungsstartbereich mit einer vorbestimmten Länge zu bilden, und nach einer zweiten vorbestimmten Zeit, die Betätigung der zweiten Reihe Fotolack-Spritzlöcher (202) wiederholt wird, bis jede der verbleibenden Reihen Fotolack-Spritzlöcher geöffnet ist, wobei dann Fotolack aufgetragen wird.

4. Verfahren gemäß Anspruch 1, weiter aufweisend:
Durchführen von Niederdrucktrocknen des Substrats (3) nach Abschluss der Fotolackauftragung.

5. Verfahren gemäß Anspruch 4, weiter aufweisend:
Durchführen von Vorbacken des Substrats (3) nach Abschluss des Niederdrucktrocknens.

6. Verfahren gemäß Anspruch 1, wobei Bewegen der Düse auf dem Substrat (3) durch den Düsen-Bewegungsmechanismus aufweist:
Bewegen der Düse (2) durch den Düsen-Bewegungsmechanismus von einer Seite des Substrats (3) bis zu der anderen Seite.

7. Verfahren gemäß Anspruch 1, wobei der Abstandshalter (4) eine Keilform aufweist.

8. Verfahren gemäß Anspruch 7, wobei ein oberes Ende des Fortsatz-Abschnitts des Abstandshalters (4) in einer Keilform eine Oberseite des darunter aufgetragenen Fotolacks berührt.

## Revendications

1. Procédé de revêtement de résine photosensible, comprenant les étapes consistant à :
déplacer une buse (2) sur un substrat (3) par un mécanisme de déplacement de buse, dans lequel au moins deux rangées de trous d'injection de résine photosensible (201, 202) sont incluses dans la buse (2), et les deux rangées adjacentes de trous d'injection de résine photosensible (201, 202) sont séparées par une entretoise (4), et
ouvrir chaque rangée de trous d'injection de résine photosensible (201, 202) dans la buse (2) de manière successive dans une direction opposée à la direction de déplacement de la buse (2) pour l'application de résine photosensible,
**caractérisé en ce que**
une portion d'extension de l'entretoise (4) s'étend d'un plan où des ouvertures des trous d'injection de résine photosensible (201, 202) sont prévues, et par la formation d'une différence de hauteur entre une extrémité supérieure d'une portion d'extension et le plan, et
une première rangée des deux rangées adjacentes des trous d'injection de résine photosensible (201, 202) est tout d'abord ouverte pour former une région de début de revêtement de résine photosensible d'une première couche de résine photosensible (5) ;
un film de protection est formé dans une surface supérieure de la région de début de revêtement de résine photosensible par le biais d'une volatilisation d'une solution dans la première couche de résine photosensible (5), et
ensuite, une seconde rangée des deux rangées adjacentes de trous d'injection de résine photosensible (201, 202) est ouverte pour former une seconde couche de résine photosensible (6), et
dans lequel il se produit une délamination de la première couche de résine photosensible (5) et de la seconde couche de résine photosensible (6) dans la région de début de revêtement de résine photosensible en raison du film de protection formé dans la surface supérieure de la région de début de revêtement de résine photosensible.

2. Procédé selon la revendication 1, dans lequel l'étape pour ouvrir chaque rangée de trous d'injection de résine photosensible (201, 202) dans la buse (2) de manière successive dans la direction opposée à la direction de déplacement de la buse (2) pour l'application de résine photosensible comprend l'étape pour :
dans une direction opposée à la direction de déplacement de la buse (2), ouvrir la première rangée de trous d'injection de résine photosensible (201) tout d'abord lors du revêtement de résine photosensible pour former la région de début de revêtement de résine photosensible de la première couche de résine photosensible (5) avec une longueur prédéterminée sur un bord du substrat (3), et après une période de temps prédéterminée, ouvrir ensuite la seconde rangée de trous d'injection de résine photosensible (202) adjacente à la première rangée de trous d'injection de résine photosensible (201).

3. Procédé selon la revendication 1, dans lequel la seconde rangée de trous d'injection de résine photosensible (202) est ouverte pour former une seconde région de début de revêtement de résine photosensible avec une longueur prédéterminée, et après une seconde période de temps prédéterminée, les opérations de la seconde rangée de trous d'injection de résine photosensible (202) sont répétées jusqu'à ce que chacune des rangées restantes des trous d'injection de résine photosensible soit ouverte, puis la résine photosensible est appliquée.

4. Procédé selon la revendication 1, comprenant en outre l'étape consistant à :
réaliser un séchage à basse pression sur le substrat (3) au terme de l'application de la résine photosensible.

5. Procédé selon la revendication 4, comprenant en outre l'étape consistant à :
réaliser une pré-cuisson sur le substrat (3) au terme du séchage à basse pression.

6. Procédé selon la revendication 1, dans lequel le déplacement de la buse (2) sur le substrat (3) par le mécanisme de déplacement de buse comprend :
le déplacement de la buse (2) par le mécanisme de déplacement de buse d'un côté du substrat (3) jusqu'à l'autre côté.

7. Procédé selon la revendication 1, dans lequel l'entretoise (4) comprend une forme de cale.

8. Procédé selon la revendication 7, dans lequel une extrémité supérieure d'une portion d'extension de l'entretoise (4) en forme de cale vient en contact avec une surface supérieure de la résine photosensible appliquée au-dessous.
